# FASCICULE DE BREVET EUROPEEN

(11) **EP 2 736 079 B1**
(45) Date de publication et mention de la délivrance du brevet: **19.08.2015**
(21) Numéro de dépôt: 13194322.7
(22) Date de dépôt: 25.11.2013
(51) Int. Cl.: H01L 29/778, H01L 21/335

(54) **Procédé de fabrication d'un transistor à hétérojonction de type normalement bloqué**
Herstellungsverfahren eines Transistors mit Heteroübergang vom Typ, der normalerweise blockiert ist
Method for manufacturing a normally blocked heterojunction transistor

(30) Priorité: 26.11.2012 FR 1261208
(43) Date de publication de la demande: 28.05.2014
(73) Titulaire: Commissariat à l'Énergie Atomique et aux Énergies Alternatives, 75015 Paris (FR)
(72) Inventeur: Charles, Matthew, 38000 GRENOBLE (FR)
(74) Mandataire: Guérin, Jean-Philippe

(56) Documents cités:
- US-A1- 2006 124 960
- US-A1- 2009 050 938
- US-A1- 2012 122 281

## Description

L'invention concerne les transistors à haute mobilité électronique basés sur la présence d'hétérojonctions, et en particulier la fabrication de tels transistors de type normalement bloqué.

De nombreuses applications électroniques nécessitent dorénavant une amélioration de performances surtout dans l'électronique embarquée à destination de l'automobile et des transports terrestres, dans l'aéronautique, dans les systèmes médicaux ou dans des solutions domotiques par exemple. Ces applications nécessitent pour la plupart des commutateurs pour forte puissance (typiquement entre 500V et plusieurs kilovolts, avec des courants le plus souvent compris entre 10 et 200 A) fonctionnant dans des gammes de fréquences fréquemment supérieures au megahertz.

Historiquement, des commutateurs de puissance ont longtemps fait appel à des transistors à effet de champ basés sur un canal semi-conducteur, le plus souvent du silicium. Pour des fréquences plus faibles, les transistors à jonction (thyristors, ...) sont préférés car ils supportent des densités de courant plus élevées. Cependant, du fait de la tension de claquage relativement limitée de chacun de ces transistors, les applications de puissance nécessitent l'utilisation d'un grand nombre de transistors en série, ou des transistors plus longs, ce qui aboutit à une résistance de passage plus élevée. Les pertes à travers ces transistors en série sont considérables, aussi bien en régime établi qu'en commutation.

Une alternative pour des commutateurs de puissance, notamment à hautes fréquences, est l'utilisation de transistors à effet de champ à haute mobilité d'électrons (HEMT), également désignés par le terme de transistor à effet de champ à hétérostructure (HFET). Un tel transistor inclut la superposition de deux couches semi-conductrices ayant des bandes interdites différentes qui forment un puit quantique à leur interface. Des électrons sont confinés dans ce puits quantique pour former un gaz bidimensionnel d'électrons. Pour des raisons de tenue en haute tension et en température, ces transistors sont choisis de façon à présenter une large bande d'énergie interdite.

Parmi les transistors HEMT à large bande d'énergie interdite (usuellement dénommée 'gap' en langue anglaise), les transistors à base de nitrure de gallium sont très prometteurs. Leur largeur de bande d'énergie interdite induit une tension d'avalanche plus haute comparée aux matériaux classiques de l'électronique (Si, SiGe, GaAs, InP), une vitesse élevée de saturation des porteurs et de bonnes stabilités thermique et chimique (permettant une utilisation dans des environnements difficiles). Le champ de claquage du nitrure de gallium peut ainsi être supérieur à 3x10⁶ V/cm, ce qui permet aisément de réaliser des transistors avec des tensions de claquage supérieures à 100 V (300 nm de GaN sont suffisants). De plus, de tels transistors permettent de très grandes densités de courant avec des pertes résistives réduites du fait de la très grande mobilité électronique dans le gaz d'interface.

Pour certaines applications, notamment en vue d'isoler un circuit en cas de dysfonctionnement d'un système de commande, on utilise des transistors du type normalement bloqué, c'est-à-dire que leur tension de seuil de commutation est positive, de sorte que le transistor reste bloqué en l'absence de signal de commande.

Du fait de la nature intrinsèquement conductrice de la couche de gaz d'électrons formée entre une source et un drain, il est technologiquement plus facile de réaliser un transistor à hétérojonction de type normalement passant. Cependant, plusieurs procédés de fabrication ont été développés en vue de former des transistors à hétérojonction de type normalement bloqué.

Selon une première approche, on réalise une couche binaire de nitrure de type III par épitaxie, on réalise ensuite une couche ternaire de nitrure de type III par épitaxie pour former une couche de gaz d'électrons à l'interface entre ces nitrures, puis on implante un dopant de type P tel que du Mg à l'intérieur de la couche binaire. Une fois l'implantation de dopant activée, le champ électrique généré par l'implant permet de créer une zone isolante à sa verticale, à l'interface entre la couche binaire de nitrure et la couche ternaire de nitrure. Ainsi, on bloque le canal de conduction dans la couche de gaz d'électrons, jusqu'à ce qu'une tension de seuil positive soit atteinte. On a cependant constaté qu'une telle implantation induisait des défauts dans la structure (surtout dans le canal dans lequel la résistance de conduction est alors accrue), et que le contrôle de l'implantation était imparfait et aboutissait à place des dopants dans le canal (ce qui augmente encore sa résistance de conduction).

Selon une seconde approche, le document WO2005/070009 décrit un procédé de fabrication dans lequel :
- une première couche de GaN est formée par épitaxie ;
- un implant à dopage de type P est formé dans la première couche de GaN ;
- une deuxième couche de GaN est formée par épitaxie sur l'implant et la première couche de GaN ;
- une couche d'AlGaN est formée par épitaxie sur la deuxième couche de GaN ;
- une grille est formée sur la couche d'AlGaN à l'aplomb de l'implant.

Le transistor ainsi obtenu présente cependant des inconvénients. En effet, le niveau du champ formé par l'implant dans le gaz d'électrons est mal contrôlé. Par conséquent, la maîtrise de la tension de seuil du transistor est imparfaite.

US2006/124960 décrit un procédé de fabrication d'un transistor à hétérojonction à effet de champ. Des dopants de type P sont implantés pour former un implant dans une première couche d'alliage semi-conducteur de type III-V, une deuxième couche d'alliage semi-conducteur de type III-V étant formée par épitaxie en phase vapeur sur l'implant. Une grille de commande est formée au-dessus de la deuxième couche, à l'aplomb de l'implant. Un tel procédé est relativement délicat à contrôler et peut induire un certain nombre de défauts dans les transistors formés.

L'invention vise à résoudre un ou plusieurs de ces inconvénients. L'invention porte ainsi sur un procédé de fabrication d'un transistor à hétérojonction à effet de champ tel que défini dans les revendications annexées.

D'autres caractéristiques et avantages de l'invention ressortiront clairement de la description qui en est faite ci-après, à titre indicatif et nullement limitatif, en référence aux dessins annexés, dans lesquels :
- les figures 1 à 7 sont des vues en coupe d'un transistor à hétérojonction à effet de champ, durant différentes étapes d'un exemple de procédé de fabrication selon l'invention ;
- les figures 8 et 9 illustrent la densité de dopant en fonction de la profondeur dans un implant, à différentes étapes du procédé de fabrication ;
- la figure 10 illustre une étape d'une variante de procédé de fabrication selon l'invention ;
- les figures 11 et 12 illustrent la densité de dopant en fonction de la profondeur dans un implant, à différentes étapes du procédé de fabrication de cette variante de procédé.

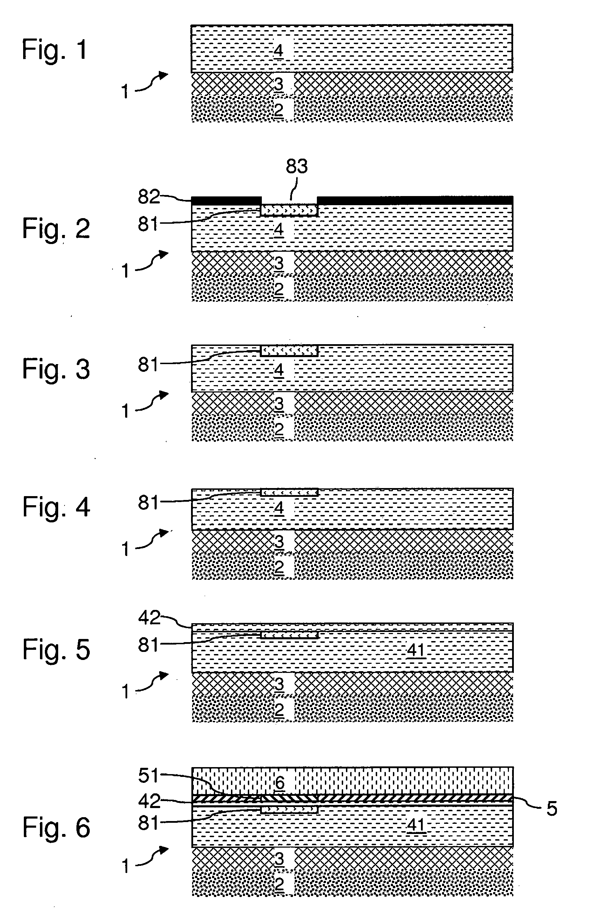

Les figures 1 à 7 sont des vues en coupe schématiques d'un transistor à hétérojonction à effet de champ 1, durant différentes étapes d'un exemple de procédé de fabrication selon l'invention.

À la figure 1, on dispose d'un précurseur du transistor 1, comportant un substrat 2, une couche tampon 3 disposée sur le substrat 2, et une première couche 4 d'un alliage de semi-conducteur de type III-V disposée sur la couche tampon 3.

Le substrat 2 peut être un isolant ou un semiconducteur de type silicium intrinsèque ou dopé. Le substrat 2 pourra par exemple être de type silicium à maille (111). Le substrat 2 peut également être du carbure de silicium, ou du saphir. Le substrat 2 peut typiquement présenter une épaisseur de l'ordre de 650 µm.

La couche tampon 3 déposée sur le substrat 2 sert d'intermédiaire entre ce substrat et la première couche d'alliage de semi-conducteur de type III-V 4, pour permettre une adaptation de maille entre le substrat 2 et cette couche 4 et pour limiter les contraintes mécaniques dans cette couche 4.

La couche 4 peut typiquement présenter une épaisseur comprise entre 100nm et 4µm. La couche 4 peut être formée de façon connue en soi par épitaxie sur la couche tampon 3. La couche 4 est typiquement un alliage de nitrure d'élément III, tel qu'un alliage binaire de nitrure d'élément III, par exemple du GaN.

À la figure 2, on a procédé de façon connue en soi à la formation d'un masque 82 sur la couche 4. Ce masque 82 comporte une ouverture 83. Une implantation de dopants de type P est réalisée dans la couche 4 à travers l'ouverture 83. Un implant 81 est ainsi formé dans la couche 4. L'implantation est typiquement réalisée par implantation ionique. L'implant 81 ainsi formé présente avantageusement une épaisseur comprise entre 5 et 100 nm. L'implant 81 pourra présenter une densité de dopants de type P maximale comprise entre 10¹⁸ et 10²¹ cm⁻³. Le type de dopants pour l'implant 81 sera avantageusement choisi par le groupe incluant Mg, Zn, C et Fe, en utilisant de préférence du Mg. Le dopage parasite d'une couche GaN en dopants de type P est usuellement d'un niveau proche de 10¹⁵ cm⁻³.

À la figure 3, on a procédé de façon connue en soi au retrait du masque 82, pour découvrir la face supérieure de la couche 4 et de l'implant 81. On place alors l'élément précurseur du transistor 1 dans des conditions d'épitaxie en phase vapeur.

À la figure 4, on retire une partie supérieure de la couche 4 et de l'implant 81, en maintenant l'élément précurseur du transistor 1 dans les conditions d'épitaxie en phase vapeur de cette couche 4 (ou de la couche 6). En l'absence d'apport de matériaux d'épitaxie, un retrait progressif s'effectue dans la partie supérieure de la couche 4. L'épaisseur de ce retrait peut être contrôlée par la durée de maintien, ainsi que par d'autres paramètres d'épitaxie, tels que la température ou l'environnement gazeux dans lequel est placé l'élément précurseur du transistor 1. Ce retrait de la partie supérieure est interrompu lorsque la densité de dopants de type P au niveau de la face supérieure de l'implant 81 est maximale. En effet, comme détaillé par la suite, lors de l'implantation, la densité des dopants de type P implantés est maximale non pas au niveau de la face supérieure de l'implant 81 mais dans la profondeur de celui-ci.

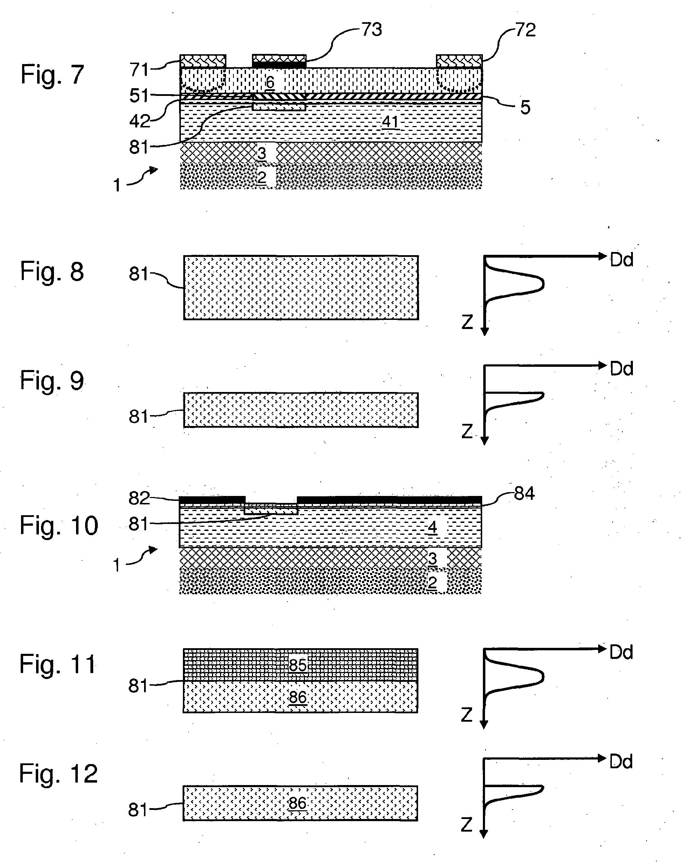

Les figures 8 et 9 illustrent schématiquement l'implant 81 et la densité de dopants de type P en fonction de la profondeur dans cet implant 81, respectivement après implantation et après retrait.

À la figure 8, l'implant 81 présente une distribution gaussienne de densité de dopants de type P dans sa profondeur à l'issue de l'implantation. À la figure 9, on a procédé au retrait d'une partie supérieure de l'implant 81, jusqu'à atteindre une surface dans laquelle la densité de dopants de type P est maximale, ce qui correspond dans cet exemple au sommet de la gaussienne. La densité de dopants de type P au niveau de la face supérieure de l'implant 81 est donc maximale.

L'implantation induit par exemple un implant 81 ayant une répartition gaussienne de densité de dopants dans sa profondeur. D'autres profils de densité d'implantation peuvent être obtenus et sont connus en soi de l'homme du métier en fonction des paramètres du processus d'implantation. La profondeur du retrait effectué dans la partie supérieure de l'implant 81 est déterminée en fonction des paramètres d'implantation. En effet, en fonction des paramètres d'implantation, il est possible de connaître la profondeur dans l'implant 81 où l'implantation induit une densité de dopants maximale. Les paramètres d'implantation pourront par exemple être définis pour que la densité maximale de dopants soit à une profondeur de 10nm dans l'implant 81. L'étape de maintien dans les conditions d'épitaxie en phase vapeur pourra avantageusement être réalisée pendant une durée comprise entre 30 secondes et 60 minutes, par exemple à une température de 1050°C, par exemple en présence d'ammoniac et/ou d'hydrogène. On réalisera typiquement un retrait d'une épaisseur d'au moins 2 nm de la partie supérieure de l'implant 81. L'étape de retrait peut servir au moins partiellement à un recuit d'activation des dopants implantés et au retrait de certaines impuretés à la surface de la couche 4.

A l'issue du retrait, la couche 4 forme une couche semi-conductrice inférieure 41. A la figure 5, on forme une deuxième couche 42 d'alliage semi-conducteur de type III-V sur l'implant 81 et sur la couche inférieure 41 par épitaxie en phase vapeur. Le dépôt de la couche 42 est typiquement effectué pleine plaque. Le dépôt de la couche 42 peut être effectué dans la même machine que l'étape de retrait, immédiatement après cette étape de retrait. Par ailleurs, du fait du procédé de retrait de la partie supérieure de la première couche 41 par maintien dans des conditions d'épitaxie, la face de cette première couche 41 est particulièrement propice à la croissance de la deuxième couche 42 par épitaxie avec une qualité optimale. Ainsi, l'interface sur laquelle la couche 42 est formée est dépourvue d'impuretés ou d'altérations indésirables.

La couche 42 peut être réalisée avec le même matériau (par exemple un alliage de nitrure de type III) que la couche 41, afin de favoriser une épitaxie sans défauts de cette couche 42 et d'éviter des effets indésirables sur le fonctionnement du transistor 1. L'épaisseur du dépôt de la couche 42 est avantageusement comprise entre 5 et 50nm. L'épaisseur du dépôt de la couche 42 est très bien contrôlée par l'intermédiaire d'un procédé de dépôt par épitaxie en phase vapeur. Par ce contrôle de l'épaisseur de la couche 42, on garantit la précision du contrôle de la tension de seuil du transistor 1, du fait de la précision du champ électrique généré par l'implant 81 dans la couche de gaz d'électrons qui va être formée.

À la figure 6, on forme une couche 6 d'alliage semi-conducteur de type III-V par épitaxie en phase vapeur sur la deuxième couche 42, de façon à former un gaz d'électrons à l'interface entre la couche 6 et la couche 42. Dans un souci de lisibilité, le gaz d'électrons est illustré sous forme de couche 5 à l'interface entre la couche 42 et la couche 6. La couche 6 est généralement désignée par le terme barrière. La couche 6 est typiquement un alliage semi-conducteur de type III-V, tel qu'un alliage ternaire de nitrure d'élément III, par exemple du AlGaN, ou une alliage binaire de nitrure d'élément III, par exemple du AIN. Une couche 6 en AlGaN est particulièrement appropriée pour une couche 42 en GaN, la formation de la couche 6 par épitaxie étant alors simplement réalisée en maintenant le précurseur du transistor 1 dans une même machine, et en réalisant une épitaxie en introduisant en supplément du précurseur de l'aluminium par rapport aux conditions d'épitaxie de la couche 42. Bien que non illustré, la couche 6 peut comprendre une couche de 1 à 3nm d'alliage binaire de nitrure de type III formée sur la couche 42, cette couche d'alliage binaire étant recouverte d'une autre couche d'alliage ternaire de nitrure de type III.

Une zone isolante 51 est formée dans la couche 5, à l'aplomb de l'implant 81. Cette zone 51 est rendue isolante par la présence du champ électrique généré par les dopants de type P de l'implant 81. Le transistor 1 est donc bloqué en l'absence de signal de commande appliqué sur la grille.

Le procédé de formation par épitaxie de la deuxième couche 42 et de la troisième couche 6 peut typiquement être un procédé du type épitaxie HVPE ou MOCVD (pour « hydride vapor phase epitaxy » et « metal organic chemical vapor deposition » en langue anglaise). Ces procédés sont typiquement mis en oeuvre en présence de vapeur d'ammoniaque ou d'hydrogène, ou d'un mélange des deux. Lorsque les conditions d'une telle épitaxie sont maintenues sur le précurseur du transistor 1, en l'absence d'apport de matériaux d'épitaxie, la partie supérieure de la première couche 41 est progressivement retirée, par sublimation du matériau de cette couche. Les conditions d'épitaxie seront adaptées aux types de semi-conducteurs des couches 4 et 6 afin que ces conditions facilitent l'étape de retrait. Pour une couche 4 en nitrure, la température dans ces conditions d'épitaxie sera typiquement supérieure à 800°C, voire supérieure à 900°C. Pour une couche 4 avec un autre semi-conducteur de type III-V, tels que le AsGa ou le InP, la température d'épitaxie sera typiquement supérieure à 500°C. Plus on augmerte la température des conditions d'épitaxie, plus la vitesse de retrait augmente.

On peut en outre noter que les conditions d'épitaxie des couches 42 et 6 permettent de réaliser l'activation de l'implant 81. Le recuit d'activation des dopants de l'implant 81 est généralement réalisé à une température comprise entre 800°C et 1500°C pour du nitrure (entre 500°C et 900°C pour d'autres semi-conducteurs de type III-V), avec une durée fonction de cette température. Il n'est ainsi pas nécessaire de réaliser une activation supplémentaire de l'implant 81 après avoir formé la couche de gaz d'électrons 5. On évite ainsi un recuit supplémentaire, facteur de dégradation du précurseur de transistor 1.

À la figure 7, on a réalisé de façon connue en soi une source 71, un drain 72 et une grille de commande 73 du transistor 1 sur la couche 6. La grille 73 est formée à l'aplomb de l'implant 81. La grille 73 déborde avantageusement latéralement par rapport à l'implant pour garantir le contrôle du transistor 1 en cas de désalignement durant le processus de fabrication. Le transistor 1 ainsi formé est donc du type normalement bloqué, la zone 51 à l'aplomb de la grille 73 étant isolante en l'absence de champ électrique approprié appliqué par la grille 73. L'influence de l'implant 81 sur la zone 51 est optimale du fait que sa face supérieure présente une densité maximale en dopants de type P, et le contrôle de la tension de seuil du transistor 1 est particulièrement précis, du fait du contrôle de la distance entre cette face supérieure et la zone 51. L'efficacité d'utilisation des dopants de type P est donc optimale. Un profil d'implantation très abrupt peut être utilisé, ce qui réduit la quantité de dopants requise ou augmente l'épaisseur du canal pour une tension de seuil donnée (la résistance de conduction dans la zone 51 étant ainsi réduite).

Par rapport à un procédé d'implantation à travers la couche de gaz d'électrons, la mobilité électronique est améliorée dans la zone 51, et la résistance de passage est réduite lorsque le transistor 1 est passant.

La figure 10 est une vue en coupe schématique d'un précurseur du transistor 1 après formation de l'implant 81 au moyen d'un masque 82, selon une variante de procédé de fabrication. Une couche sacrificielle 84 est déposée sur la couche 4 préalablement à la formation du masque 82. La couche sacrificielle 84 est formée dans un autre matériau que la couche 4. Le masque 82 est donc formé sur la couche sacrificielle 84. L'implant 81 est donc formé par implantation ionique dans la couche sacrificielle 84 et dans la couche 4. La couche sacrificielle 84 peut par exemple être une couche métallique ou une couche d'oxyde de silicium.

Le dépôt de la couche sacrificielle 84 est effectué de sorte que son épaisseur corresponde à la profondeur d'implantation de l'implant 81 pour laquelle on obtient un pic de densité de dopants de type P, comme illustré dans l'exemple de la figure 11. La figure 11 illustre l'implantation de la figure 10 en section transversale grossie, une partie 85 de l'implantation étant formée dans la couche sacrificielle 84, l'autre partie 86 de l'implantation étant formée dans la couche 4. On utilise une couche sacrificielle 84 dans un matériau susceptible d'être retiré progressivement par un maintien dans des conditions d'épitaxie.

Comme illustré à la figure 12, on procède au retrait de la couche sacrificielle 84 jusqu'à atteindre l'interface entre la couche sacrificielle 84 et la couche 4, au niveau de laquelle la densité de dopants est optimale. Ce retrait est réalisé progressivement en maintenant l'élément précurseur du transistor 1 dans des conditions d'épitaxie. L'implant 81 obtenu à la figure 12 présente donc une densité optimale en dopants de type P.

On peut choisir un métal approprié comme matériau de la couche sacrificielle 84, de sorte que des ions de ce métal migrent dans la couche 4 durant l'implantation, de façon à former des dopants de type P additionnels. Ces ions peuvent être activés dans la couche 4 lors de la même étape de recuit que les dopants de type P ayant fait l'objet de l'implantation.

La variante décrite en référence aux figures 1 à 9 sera généralement favorisée, cette variante induisant moins de risques d'introduction d'éléments indésirables au niveau des couches 4 et 6.

Dans les exemples qui sont détaillés auparavant, les couches 4 et 6 sont des nitrures d'éléments de type III. D'autres alliages semi-conducteurs parmi les alliages semi-conducteurs de type III-V peuvent également être utilisés pour les couches 4 et 6. On peut par exemple envisager de former les couches 4 ou 6 avec du InP ou du GaAs.

Les inventeurs ont également déterminé qu'une adaptation du procédé de fabrication à une première couche semi-conductrice 4 en alliage de Silicium-Germanium était possible. Il est ainsi possible de réaliser une implantation de type P dans une telle couche, puis de procéder au retrait d'une partie supérieure de cette couche en la maintenant dans des conditions d'épitaxie en phase vapeur.

## Revendications

1. Procédé de fabrication d'un transistor à hétérojonction à effet de champ (1), comprenant les étapes de :
- implantation de dopants de type P pour former un implant (81) dans une première couche d'alliage semi-conducteur de type III-V (41) ;
- retrait d'une partie supérieure de la première couche (41) et de l'implant (81) par maintien de conditions d'épitaxie en phase vapeur ;
- interruption du retrait lorsque la densité dudit dopant au niveau de la face supérieure de l'implant (81) est maximale ;
- formation d'une deuxième couche d'alliage semi-conducteur de type III-V (42) par épitaxie en phase vapeur sur ledit implant (81) et la première couche;
- formation d'une troisième couche d'alliage semi-conducteur de type III-V (6) par épitaxie en phase vapeur de façon à former une couche de gaz d'électrons (5) à l'interface entre cette troisième couche (6) et la deuxième couche;
- formation d'une grille de commande (73) au-dessus de la troisième couche (6) à l'aplomb dudit implant (81).

2. Procédé de fabrication selon la revendication 1, dans lequel ladite étape de retrait est effectuée en présence de vapeurs d'ammoniaque, d'hydrogène ou d'un mélange des deux.

3. Procédé de fabrication selon la revendication 1 ou 2, dans lequel ladite étape de retrait est effectuée par maintien des conditions d'épitaxie en phase vapeur pendant une durée comprise entre 30 secondes et 60 minutes.

4. Procédé de fabrication selon l'une quelconque des revendications précédentes, dans lequel l'implant (81) est formé avec une épaisseur comprise entre 5 et 100 nm dans la première couche.

5. Procédé de fabrication selon la revendication 4, dans lequel ladite étape de retrait inclut le retrait d'au moins 2 nm de la partie supérieure de l'implant (81).

6. Procédé de fabrication selon l'une quelconque des revendications précédentes, dans lequel la densité dudit dopant dans la face supérieure de l'implant (81) est comprise entre 10¹⁸ et 10²¹ cm⁻³.

7. Procédé de fabrication selon l'une quelconque des revendications précédentes, dans lequel la deuxième couche (42) est formée avec une épaisseur comprise entre 5 et 50 nm.

8. Procédé de fabrication selon l'une quelconque des revendications précédentes, dans lequel la première couche et la deuxième couche incluent majoritairement un alliage binaire de nitrure.

9. Procédé de fabrication selon la revendication 8, dans lequel ledit alliage binaire de nitrure est du GaN.

10. Procédé de fabrication selon l'une quelconque des revendications précédentes, dans lequel la troisième couche (6) inclut majoritairement un alliage ternaire de nitrure.

11. Procédé de fabrication selon la revendication 10, dans lequel ledit alliage ternaire de nitrure est du AlGaN.

12. Procédé de fabrication selon l'une quelconque des revendications 8 à 11, dans lequel ladite étape de retrait est effectuée à une température au moins égale à 800 ° C.

13. Procédé de fabrication selon l'une quelconque des revendications précédentes, dans lequel les dopants de l'implant formé sont choisis dans le groupe comprenant Mg, Zn, C, et Fe.

14. Procédé de fabrication selon l'une quelconque des revendications précédentes, dans lequel ladite implantation de dopants est effectuée par implantation ionique.

15. Procédé de fabrication selon l'une quelconque des revendications précédentes, dans lequel une activation de l'implant est réalisée au moins partiellement durant ladite étape de retrait.

## Patentansprüche

1. Verfahren zur Herstellung eines Feldeffekttransistors mit Heteroübergang (1), umfassend die folgenden Schritte:
- Implantationvon Dotierungsstoffen des Typs P, um ein Implantat (81) in einer ersten Halbleiterlegierungsschicht des Typs III-V (41) zu bilden;
- Entfernen eines oberen Teils der ersten Schicht (41) und des Implantats (81), durch Aufrechterhaltung von Epitaxiebedingungen in Dampfphase;
- Unterbrechen des Entfernens, wenn die Dichte des Dotierungsstoffes im Bereich der Oberseite des Implantats (81) maximal ist;
- Bilden einer zweiten Halbleiterlegierungsschicht des Typs III-V (42) durch Epitaxie in Dampfphase auf dem besagten Implantat (81) und der ersten Schicht;
- Bilden einer dritten Halbleiterlegierungsschicht des Typs III-V (6) durch Epitaxie in Dampfphase, um eine Elektronengasschicht (5) an der Schnittstelle zwischen dieser dritten Schicht (6) und der zweiten Schicht zu bilden;
- Bilden eines Steuergates (73) über der dritten Schicht (6) senkrecht auf das Implantat (81).

2. Herstellungsverfahren nach Anspruch 1, bei dem der Schritt des Entfernens im Beisein von Ammoniak-, Wasserstoffdämpfen oder einem Gemisch aus beiden erfolgt.

3. Herstellungsverfahren nach Anspruch 1 oder 2, bei dem der Schritt des Entfernens durch Aufrechterhaltung der Epitaxiebedingungen in Dampfphase während einer Dauer zwischen 30 Sekunden und 60 Minuten erfolgt.

4. Herstellungsverfahren nach einem der vorhergehenden Ansprüche, bei dem das Implantat (81) mit einer Dicke zwischen 5 und 100 nm in der ersten Schicht gebildet ist.

5. Herstellungsverfahren nach Anspruch 4, bei dem der Schritt des Entfernens das Entfernen von mindestens 2 nm des oberen Teils des Implantats (81) einschließt.

6. Herstellungsverfahren nach einem der vorhergehenden Ansprüche, bei dem die Dichte des Dotierungsstoffes in der Oberseite des Implantats (81) zwischen 10¹⁸ und 10²¹ cm⁻³ beträgt.

7. Herstellungsverfahren nach einem der vorhergehenden Ansprüche, bei dem die zweite Schicht (42) mit einer Dicke zwischen 5 und 50 nm gebildet ist.

8. Herstellungsverfahren nach einem der vorhergehenden Ansprüche, bei dem die erste Schicht und die zweite Schicht mehrheitlich eine binäre Nitridlegierung einschließen.

9. Herstellungsverfahren nach Anspruch 8, bei dem die binäre Nitridlegierung GaN ist.

10. Herstellungsverfahren nach einem der vorhergehenden Ansprüche, bei dem die dritte Schicht (6) mehrheitlich eine ternäre Nitridlegierung einschließt.

11. Herstellungsverfahren nach Anspruch 10, bei dem die ternäre Nitridlegierung AlGaN ist.

12. Herstellungsverfahren nach einem der Ansprüche 8 bis 11, bei dem der Schritt des Entfernens bei einer Temperatur mindestens gleich 800°C erfolgt.

13. Herstellungsverfahren nach einem der vorhergehenden Ansprüche, bei dem die Dotierungsstoffe des gebildeten Implantats in der Gruppe, umfassend Mg, Zn, C und Fe, ausgewählt sind.

14. Herstellungsverfahren nach einem der vorhergehenden Ansprüche, bei dem die Implantation von Dotierungsstoffen durch Ionenimplantation erfolgt.

15. Herstellungsverfahren nach einem der vorhergehenden Ansprüche, bei dem eine Aktivierung des Implantats zumindest teilweise während des Schrittes des Entfernens erfolgt.

## Claims

1. Process for manufacturing a heterojunction field-effect transistor (1), comprising steps of:
- implantation of p-type dopants in order to form an implant (81) in a first layer (41) of III-V semiconductor alloy;
- removing an upper part of the first layer (41) and of the implant (81) by maintaining vapour phase epitaxy conditions;
- stopping the removal when the density of said dopant at the upper face of the implant (81) is maximal;
- forming a second layer (42) of III-V semiconductor alloy by vapour phase epitaxy on said implant (81) and the first layer;
- forming a third layer (6) of III-V semiconductor alloy by vapour phase epitaxy in order to form an electron gas layer (5) at the interface between this third layer (6) and the second layer; and
- forming a control gate (73) above the third layer (6) plumb with said implant (81).

2. Manufacturing process according to Claim 1, in which said removal step is carried out in the presence of ammonia vapours, hydrogen vapours or a mixture of both.

3. Manufacturing process according Claims 1 or 2, in which said removal step is carried out by maintaining vapour phase epitaxy conditions for a length of time comprised between 30 seconds and 60 minutes.

4. Manufacturing process according to any one of the preceding claims, in which the implant (81) is formed with a thickness comprised between 5 and 100 nm in the first layer.

5. Manufacturing process according to Claim 4, in which said removal step includes removing at least 2 nm of the upper part of the implant (81).

6. Manufacturing process according to any one of the preceding claims, in which the density of said dopant at the upper side of the implant (81) is comprised between 1×10¹⁸ and 1×10²¹ cm⁻³.

7. Manufacturing process according to any one of the preceding claims, in which the second layer (42) is formed with a thickness comprised between 5 and 50 nm.

8. Manufacturing process according to any one of the preceding claims, in which the first layer and the second layer mainly include a binary nitride alloy.

9. Manufacturing process according to Claim 8, in which said binary nitride alloy is GaN.

10. Manufacturing process according to any one of the preceding claims, in which the third layer (6) mainly includes a ternary nitride alloy.

11. Manufacturing process according to Claim 10, in which said ternary nitride alloy is AlGaN.

12. Manufacturing process according to any one of Claims 8 to 11, in which said removal step is carried out at a temperature at least equal to 800°C.

13. Manufacturing process according to any one of the preceding claims, in which the dopants of the formed implant are chosen from the group comprising Mg, Zn, C, and Fe.

14. Manufacturing process according to any one of the preceding claims, in which said dopants are implanted by ion implantation.

15. Manufacturing process according to any one of the preceding claims, in which the implant is activated at least partially during said removal step.
